# EUROPEAN PATENT APPLICATION

(11) **EP 4 064 340 A1**
(43) Date of publication of application: **28.09.2022**
(21) Application number: 21164586.6
(22) Date of filing: 24.03.2021
(51) Int. Cl.: H01L 23/498

(54) **POWER SEMICONDUCTOR MODULE AND MANUFACTURING METHOD**

(71) Applicant: Hitachi Energy Switzerland AG, 5400 Baden (CH)
(72) Inventor: GUILLON, David, 8857 Vorderthal (CH); MALEKI, Milad, 5417 Untersiggenthal (CH)
(74) Representative: Epping - Hermann - Fischer

(57) **Abstract**

In one embodiment, the power semiconductor module (1) comprises:
- a main substrate (2),
- at least one first semiconductor chip (3) mounted on the main substrate (2), and
- at least one auxiliary substrate (4) mounted on the main substrate (2), the at least one auxiliary substrate (4) comprises a top face (40) remote from the main substrate (2), wherein
- the at least one auxiliary substrate (4) comprises an insulation layer (41) which is based on an organic material and which is in direct contact with the main substrate (2), and comprises a top metal layer (42) forming at least part of the top face (40).

## Description

A power semiconductor module is provided. Further, a method for manufacturing such a power semiconductor module is also provided.

Document JP 2209787 A2 refers to a method for preparing a printed circuit board, where the printed circuit board is mounted to an aluminum block by means of a polyimide resin layer.

Document CN 203367241 U refers to a structure of a molded power package, where a printed circuit board is joined to a leadframe by wires or by a silver containing adhesive paste.

Document JP 6342986 A2 discloses a multilayer substrate with two circuit layers interconnected by vias or through holes, the circuit layers are mounted to a metal baseplate by means of an insulating coating and an adhesive agent.

A problem to be solved is to provide a power semiconductor module that can efficiently be manufactured.

This object is achieved, inter alia, by a power semiconductor module and by a method as defined in the independent patent claims. Exemplary further developments constitute the subject matter of the dependent claims.

For example, the power semiconductor module uses an insulated metal substrate, IMS for short, as an auxiliary substrate on a main substrate in order to provide a contact platform for electrical wiring of one or of a plurality of first semiconductor chips, like power chips. Using the IMS instead of, for example, a direct bonded copper substrate, DBC substrate for short, costs can be reduced and additional flexibility in circuitry can be gained.

In at least one embodiment, the power semiconductor module comprises:
- one or a plurality of main substrates, wherein the at least one mains substrate is, for example, a DBC substrate,
- one or a plurality of first semiconductor chips mounted on the main substrate, and
- at least one auxiliary substrate also mounted on the main substrate, the at least one auxiliary substrate comprises a top face remote from the main substrate, the at least one auxiliary substrate is, for example, an IMS-based substrate,
wherein the at least one auxiliary substrate comprises an insulation layer which is based on an organic material and which is in direct contact with the main substrate, and also comprises a top metal layer forming at least part of the top face.

The term 'power semiconductor module' means, for example, that the module is configured for high currents. For example, the power semiconductor module is configured to handle a maximum current of at least 10 A or of at least 50 A or of at least 100 A or of at least 500 A. Correspondingly, the at least one first semiconductor chip may be high-power chip.

According to at least one embodiment, the at least one auxiliary substrate is attached to the main substrate by means of the insulation layer. This is done, for example, by thermal treatment of the insulation layer, wherein application of pressure can also be included. In other words, in this case the at least one auxiliary substrate may not comprise an inherently adhesive layer like a duct tape, but requires elevated temperatures to be attached. Accordingly, between the main substrate and the at least one auxiliary substrate there is no additional adhesive like a glue, a solder or a sinter layer.

According to at least one embodiment, the top metal layer is in direct contact with the insulation layer. For example, the insulation layer is the only layer between the top metal layer and the main substrate.

According to at least one embodiment, the insulation layer comprises one or a plurality of resin layers or consists of one or a plurality of resin layers. As an option, the resin layer, or at least one of the resin layers, or all the resin layers, are filled with an inorganic filler like inorganic particles. To increase thermal conductivity of the insulation layer, the at least one inorganic filler can be a ceramic material like AlN, Al₂O₃, Si₃N₄, or BN.

According to at least one embodiment, the insulation layer comprises a bottom sub-layer directly between the resin layer and the main substrate. For example, the bottom sub-layer is of a resin like an epoxy resin. Compared with the resin layer, the bottom sub-layer is thin. This may mean that a sub-layer thickness is at most 30% or at most 20% or at most 5% of an overall thickness of the insulation layer. Between the resin layer and the top metal layer, there may be a top sub-layer; the top sub-layer and the bottom sub-layer may be of identical construction.

According to at least one embodiment, the power semiconductor module comprises a plurality of the first semiconductor chips. All the first semiconductor chips can be mounted on the same main substrate. All the first semiconductor chips can be of the same type, or there are different types of first semiconductor chips, like diodes and transistors.

According to at least one embodiment, the at least one auxiliary substrate provides a common contact platform for one, for some or for all of the first semiconductor chips. This may mean that from each respective first semiconductor chips an electric connection means, like a bond wire, runs onto the at least one auxiliary substrate, or this may mean that from contact surfaces, the respective first semiconductor chip is mounted on, at least one electric connection means runs onto the at least one auxiliary substrate. In other words, the respective contact surface of the main substrate or the respective fist semiconductor chip can directly be electrically connected with the at least one auxiliary substrate, for example, with the top face.

According to at least one embodiment, the at least one auxiliary substrate comprises or carries a further electric component. Such a further electric component may be mounted on the top face, or may be integrated in the at least one auxiliary substrate. For example, the at least one further electric component is a resistor or a sensor or a switch or an integrated circuit, IC for short.

According to at least one embodiment, the at least one auxiliary substrate is a multi-layer substrate. Hence, the at least one auxiliary substrate can comprise one or a plurality of interior conductive layers and/or one or a plurality of interior insulating layers. The at least one interior conductive layer and the at least one interior insulating layer are thus located partially or completely between the insulator layer at a bottom side of the at least one auxiliary substrate and the top metal layer at the top face. Seen in top view of a top layer of the main substrate, alternatively referred to as top side, the top metal layer and the at least one interior conductive layer may have different sizes, or also the same size. That is, the at least one interior conductive layer and the top metal layer may be congruent, but do not need to be congruent.

According to at least one embodiment, the top face of the auxiliary substrate comprises or consists of the top metal layer, wherein at places the top face could be formed by at least one interior conductive layer protruding from the top metal layer. For example, said respective layer is configured for wire bonding, for example, with wire bonds made of aluminum or copper. As an alternative to wire bonds, ribbons, foils or clips or the like can be used, too. The respective layer can be a continuous, flat layer. The top metal layer and the at least one protruding interior conductive layer can be the only components on the top face, except for the electrical connection means.

According to at least one embodiment, an electrical connection between the auxiliary substrate and the main substrate is also established by at least one electrical connection means like a bond wire, a ribbon, a foil or a clip, for example, by a plurality of electrical connection means. The at least one electrical connection means can run from the main substrate to the top face of the auxiliary substrate, or to electrical components mounted on the top face.

According to at least one embodiment, the at least one first semiconductor chip is selected from the group comprising or consisting of a metal-oxide-semiconductor field-effect transistor, MOSFET for short, a metal-insulator-semiconductor field-effect transistor, MISFET for short, an insulated-gate bipolar transistor, IGBT for short, a bipolar junction transistor, BJT for short, a gate turn-off thyristor, GTO for short, a gate commutated thyristor, GCT for short, a junction gate field-effect transistor, JFET for short, and a diode. If there is a plurality of the first semiconductor chips, all the first semiconductor chips can be of the same type, or there are different kinds of first semiconductor chips.

The power semiconductor module is, for example, a power module in a vehicle to convert direct current from a battery to alternating current for an electric motor, for example, in hybrid vehicles or plug-in electric vehicles, or in a train like a commuter train.

A method for manufacturing the power semiconductor module is additionally provided. By means of the method, a power semiconductor module is produced as indicated in connection with at least one of the above-stated embodiments. Features of the power semiconductor module are therefore also disclosed for the method and vice versa.

In at least one embodiment, the method is for manufacturing the power semiconductor module and comprises the following method steps, for example, in the stated order:
A) providing the main substrate, and
B) mounting the at least one auxiliary substrate onto the main substrate.

In method step B), mounting the at least one auxiliary substrate comprises applying an elevated temperature on the respective insulation layer. In step B) a geometry and/or shape of a material of the insulation layer can still be well-defined, or the geometry and/or shape of the insulation layer is defined not until step B).

According to at least one embodiment, a fabricating of the at least one auxiliary substrate is done prior to step B) and the fabricating comprises the following steps, for example, in the stated order:
C1) providing the top metal layer,
C2) providing the insulation layer, and
C3) laminating the top metal layer onto the insulation layer.

In this case, in step B) the at least one auxiliary substrate may be laminated onto the main substrate. For example, during lamination the at least one auxiliary substrate is heated and pressed onto the main substrate so that the insulation layer partially melts or softens, and upon hardening or solidifying, the at least one auxiliary substrate is fixedly bound to the main substrate.

According to at least one embodiment, a fabricating of the at least one auxiliary substrate comprises the following steps, for example, in the stated order:
C1) providing the top metal layer,
C4) arranging the main substrate and the top metal layer in their final relative positions,
C5) creating the insulation layer between the main substrate and the top metal layer.

In this case, step C5) may include molding or casting the insulation layer. Hence, the shape of the insulation layer is defined in method step C5) which is part of step B), while method step C1) is done prior to step B). Step C4) can also be part of method step B).

A power semiconductor module and a method described herein are explained in greater detail below by way of exemplary embodiments with reference to the drawings. Elements which are the same in the individual figures are indicated with the same reference numerals. The relationships between the elements are not shown to scale, however, but rather individual elements may be shown exaggeratedly large to assist in understanding.

In the figures:
- Figure 1: is a schematic sectional view of a modification of a power semiconductor module,
- Figure 2: is a schematic sectional view of an exemplary embodiment of a power semiconductor module described herein,
- Figure 3: is a schematic top view of an exemplary embodiment of a power semiconductor module described herein,
- Figure 4: is a schematic sectional view of an auxiliary substrate for exemplary embodiments of a power semiconductor module described herein,
- Figures 5 to 7: are schematic top views of auxiliary substrates for exemplary embodiments of a power semiconductor module described herein,
- Figure 8: is a schematic sectional view of an exemplary embodiment of a power semiconductor module described herein, and
- Figure 9 and 10: are schematic block diagrams of exemplary embodiments of methods for manufacturing power semiconductor modules described herein.

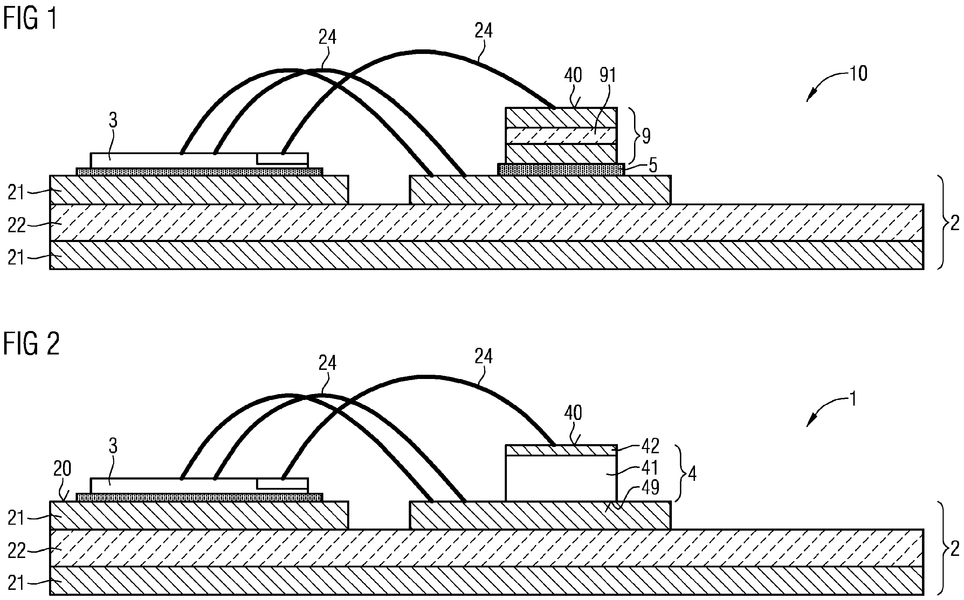

Figure 1 illustrate a modified power semiconductor module 10. The module 10 comprises a main substrate 2 and a further substrate 9. Both substrates 2, 9 are DBC substrates. The further substrate 9 is connected to the main substrate 2 by means of a joining layer 5 which may be a solder layer.

The main substrate 2 comprises a central ceramic layer 21, corresponding to the ceramic layer 91 of the further substrate 9. There are metallizations 22 on both sides of each one of the respective central ceramic layers 21, 91. An electrical connection between a top face 40 of the further substrate 9 and first semiconductor chips 3 on the main substrate 2 is achieved by means of a plurality of electric connection means 24, like bond wires. Because Figure 1 is a sectional view, only one of the plurality of the first semiconductor chips 3 can be seen.

In power semiconductor modules, the operation of the switching devices, that is, of the first semiconductor chips 3, is typically controlled by gate signals. Therefore, the gate contacts of all switching devices should be interconnected with an external gate terminal of the power module. Each switching device should have its own interconnection of the gate provided by the further substrate 9. Additionally, the delay of gate signals due to electromagnetic coupling should be homogeneous for all first semiconductor chips 3 to provide simultaneous switching.

The interconnection of the gates of all first semiconductor chips 3, that is, the bond wire connections, consumes much space of the main substrate 2 to provide a metallization pattern for the gate or control circuit, for example, in power modules, where many first semiconductor chips 3 are mounted on the main substrate 2 like it is in power modules with wide bandgap devices.

Even more important, the two-layer design having the substrates 2, 9 allows for fast and clear switching, when the further substrate 9 is mounted on top of the circuit pattern of source or emitter/source in case of a power MOSFET or a power MISFET or an IGBT, respectively.

In addition, this demand of space enhances the size of the main substrate resulting in an increase of the costs of the main substrate and, consequently, of the power module. For example, a power module may contain up to 20 SiC Power MOSFET devices as the first semiconductor chips 3, which consequently need in sum 20 gate interconnections.

As illustrated in Figure 1, the further substrates 9 are typically DBC substrates comprising or consisting of the electrically insulating ceramic layer 21 and the metallizations 22 on the top layer 20 and on the back side of said ceramic layer 21. The further substrate 9 is joined to the main substrate 2 by gluing, sintering, or soldering. Consequently, an additional joining process is needed to attach the further substrate 9 to the main substrate 2. Gate resistors can also be mounted on the further substrate 9, not shown in Figure 1.

However, the use of DBC based further substrates 9, which are joined to the metallization pattern of the main substrate 2, has some disadvantages:
- DBC substrates based on an electrically insulating ceramic sheet are causing high costs. So even a small DBC substrate based on comparably cheap aluminum oxide ceramic has a price of about 1 CHF. Moreover, manufacturing of small DCBs is challenging on supplier side and typically is associated with a low yield.
- A DBC substrate in the low-cost region has no structures in the metallization pattern. Then, only a homogenous single layer metallization for a control circuit is available. So no specific layout of a control circuit for an improvement of the electromagnetic behaviour is possible, for example, because preparation of individual small-size conductor traces is not possible on DBC substrates.
- A separate joining process of gluing, soldering, or sintering with thermal impact is needed to join the further substrate 9 to the main substrate 2.
- There is a need of investment for gluing machines and tools.
- A contamination of regions of the power circuit metallization of the main substrate 2 neighbouring the joining connection of the further substrate 9 during the joining process cannot be excluded. This may result in a poor process capability of, for example, wirebond connections or in the demand of safety spaces for proper processing.
- When preparing joining connections by gluing, there is a large thermal resistance between the main substrate and the auxiliary substrate. This may make the implementation of, for example, thermal sensors or heat generating devices to the auxiliary substrate less advantageous.

Thus, the use of, for example, DBC based further substrates 9, which are mounted to the main substrate 2 by gluing, soldering or sintering, has some disadvantages. Overcoming theses disadvantages can be achieved by using an auxiliary substrate 4 based on insulated metal substrate, IMS, technology, which will provide a cheap and reliable technology for low voltage circuitry.

In the present power semiconductor module 1, the further substrate 9 of Figure 1 made of direct bonded copper is replaced by an auxiliary substrate 4 made of an insulation layer 41 next to the main substrate 2 and of a top metal layer 41 on a top face 40 facing away from the main substrate 2. By means of such an auxiliary substrate 4, for example, interconnections of gate contacts of the first semiconductor chips 3 can be provided, see Figure 2.

Thus, in the power semiconductor module described therein the technology of insulated metal substrates is used as an alternative to DBC substrates or printed circuit boards. Insulated metal substrates used as auxiliary substrates are composed of an electrically isolating resin sheet for the insulation layer 41 having a thickness in the range of, for example, 0.05 mm to 0.3 mm, and a laminated metal foil used as the top metal layer 42, where, for example, wirebonds or active and passive electrical devices are joined. Finally, the corresponding auxiliary substrate 4 is joined to the a top layer 20 of the main substrate 2 by a lamination process applying temperature and optionally pressure. Consequently, the implementation of the auxiliary substrate 4 to the main substrate 2 can be integrated into a manufacturing process of the main substrate 2.

The realization of auxiliary substrates 4 based on IMS technology instead of a DBC substrate 9 provides some business benefits, for example:
- The material price of an IMS based auxiliary substrate 4 is much lower than for a DBC substrate. IMS based auxiliary substrates 4 have a price of about 0.10 CHF/piece, whereas the price of corresponding DBC substrates 9 is around 1.00 CHF/piece.
- Because of no explicit joining connection, like gluing, soldering, sintering, a more direct thermal path is provided between the main substrate 2 and the auxiliary substrate 4. This may facilitate the implementation of sensors, like thermal sensors, on the top face 40 of the auxiliary substrate 4. The IMS-based auxiliary substrate 4 itself may also have an increased higher thermal conductivity compared, for example, with PCB-based auxiliary substrates.
- The enhanced price of the IMS-based auxiliary substrate 4 is at least partly compensated for by no demand of an explicit joining process, contrary to what is required when using cheaper PCB-based auxiliary substrates. Main substrates 2 carrying implemented IMS auxiliary substrates 4 may be ordered directly from the substrate supplier of the main substrate 2.
- Compared with joining processes needed for DBC or PCB substrates, a lamination process used for the auxiliary substrates 4 described herein allows a more exact positioning on the main substrate 2 without generation of contaminations. Consequently, there is less demand of costly main substrate area to be used for positioning tolerances and safety margins with respect to contaminations.
- The use of IMS-based auxiliary substrates 4 may be interesting in intelligent power semiconductor modules 1 for mounting of control devices, like ICs, that have an only moderate heat generation, which does not need a high, but only a considerable heat dissipation.
- The thermo-mechanical properties of the IMS-based auxiliary substrates 4 are closer to the corresponding properties of epoxy mold compared with printed circuit boards. Consequently, thermo-mechanical stress inside the power semiconductor module 1 is reduced. Humidity uptake of IMS-based auxiliary substrates 4 is also not worse than that of printed circuit boards.

The insulation layer 41 is made, for example, of a resin like an epoxy resin. A thickness of the insulation layer 41 is, for example, at least 50 µm or at least 100 µm and/or at most 0.5 mm or at most 0.3 mm. A thickness of the top metal layer 42 is, for example, at least 1 µm or at least 5 µm and/or at most 0.2 mm or at most 0.1 mm. The top metal layer 42 may have a constant thickness and/or may cover the whole insulation layer 41 so that the top face 40 may consist of the top metal layer 42. By means of the electrically insulating insulation layer 41, the top metal layer 42 can electrically be separated from the main substrate 2, in particular from the metallization 22 at the top layer 20. The insulation layer 41 is in direct contact with the top layer 20.

The top metal layer 42 and/or the metallizations 22 can be made of at least one of aluminum, an aluminum alloy, copper, a copper alloy. It is possible that the top metal layer 42 and/or the metallizations 22 are of single layer fashion or also of multi-layer fashion; in the latter case, the top metal layer 42 and/or the metallizations 22 comprise multiple metallic layers.

For example, the power semiconductor module 1 comprises at least three or at least four of the first semiconductor chips 3 for which the at least one auxiliary substrate 4 can provide a common contact platform. Optionally, there are at least eight or at least ten first semiconductor chips 3. Alternatively or additionally, the number of first semiconductor chips 3 is at most 50 or at most 30 or at most 15. Concerning these numbers, the same can apply to optionally present other semiconductor chips mounted on the main substrate 2 or on the at least one auxiliary substrate 4.

It might be noted that the positive effects of auxiliary substrates 4 based on IMS technology are more significant for power semiconductor modules 1 where a large number of first semiconductor chips 3 is mounted on the main substrate 2, as it is the situation in, for example, wide-bandgap products like in the automotive branch, where, for example, up to 20 SiC MOSFETs are mounted to the main substrate 2 that may have lateral dimensions of about 60 x 60 mm². As an option, individually or together, the following may apply: An overall thickness of the auxiliary substrate 4 is, for example, at least 0.2 mm and at most 3 mm. Alternatively or additionally, lateral dimensions of the auxiliary substrate 4, seen in top view of the top face 40, may be at least 1 mm x 20 mm and/or at most 15 mm x 150 mm.

As mentioned above, the main substrate 2 can be a direct bonded copper substrate comprising the central ceramic layer 21 and at least one metallization 22 on each main side of the ceramic layer. As an alternative, the main substrate 2 can be an active metal brazed substrate, AMB substrate for short. Hence, the main substrate 2 can efficiently be configured for high electrical loads.

For example, only the main substrate 2, and not the auxiliary substrate 4, is configured for large currents. For example, the auxiliary substrate 4 is configured for a maximum current of 5 A or less, or of 2 A or less, or of 1 A or less.

Otherwise, the same as to Figure 1 may also apply to Figure 2.

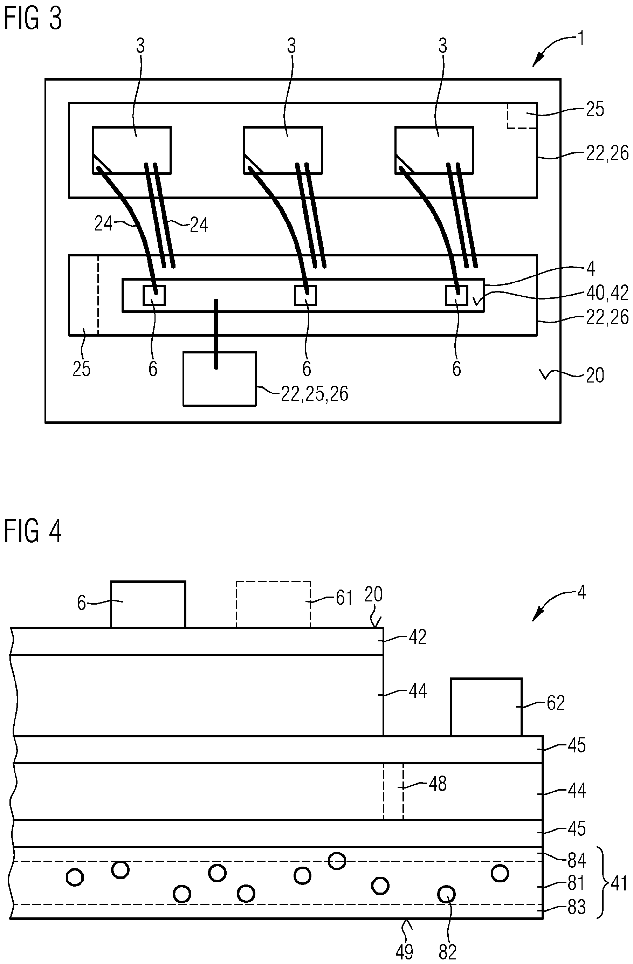

Figure 3 illustrates an exemplarily power semiconductor module 1 comprising a plurality of the power MOSFFET devices, that is, of the first semiconductor chips 3, for example, three of the first semiconductor chips 3. The first semiconductor chips 3 may be of the same type. The first semiconductor chips 3 are arranged, for example, in one line next to the auxiliary substrate 4. The first semiconductor chips 3 are electrically connected to the auxiliary substrate 4 by means of electric connection means 24, which are, for example, bond wires. Instead of the bond wires, other electrical connection means like ribbons, foils or clamps can be used, too. The same is true for all other exemplary embodiments.

The IMS-based auxiliary substrate 4 can be mounted on a conductor path 26 formed in the metallization 22 on the top layer 20 of the main substrate 2. The first semiconductor chips 3 are electrically directly connected both to said metallization 22 and to the top face 40 of the auxiliary substrate 4. However, there is no direct electric connection between said metallization 22 and the top face 40. That is, there can be two different and separate circuitries, one on the auxiliary substrate 4 and one on the main substrate 2.

Moreover, there is at least one additional electric connection means 24 to at least one other conductor path 26 of the main substrate 2 to the top face 40 so that the top face 40 can serve as a common gate contact for all the first semiconductor chips 3, for example. Thus, the conductor paths 26 can be contact surfaces for the electric connection means 24. Optionally, the conductor paths 26 comprise terminal regions 25 which are configured to electrically contact the power semiconductor module 1.

As an option, on the top face 40 there are resistors 6. The resistors 6 have direct electric contact to the top metal layer 42 and also to the first semiconductor chips 3 by means of the electric connection means 24. For example, each first semiconductor chip 3 is contacted to its own resistor 6. To compensate for different electrical path lengths, the resistors 6 can have slightly different resistances, for example, in the range from 1 Ω to 10 Ω. The same can apply to all other exemplary embodiments.

For example, the first semiconductor chips 3 are electrically contacted in parallel or anti-parallel. Thus, the auxiliary substrate 4 can serve as the common contact platform for some or for all of the first semiconductor chips 3.

For example, the common contact platform is a gate contact for the first semiconductor chips 3. Thus, controlling the first semiconductor chips 3 can be achieved by means of the auxiliary substrate 4. Hence, the auxiliary substrate 4 is, for example, used for the interconnection of the gates of the respective first semiconductor chips 3, and not for a power circuitry. In addition, the auxiliary substrate 4 may also be used for other auxiliary connections like an auxiliary emitter, a collector contact or a drain/source contact, or for interconnection of further electrical components like sensors.

Otherwise, the same as to Figure 2 may also apply to Figure 3, and vice versa.

In Figure 4, an exemplary embodiment of the auxiliary substrate 4 is illustrated in more detail. Said auxiliary substrate 4 can be used in all exemplary embodiments. The auxiliary substrate 4 is of multi-layered fashion and comprises, in addition to the top metal layer 42 at the top face 40, interior conductive layers 45 and interior insulating layers 44. The interior conductive layers 45 and interior insulating layers 44 can be congruent with the insulator layer 41 and the top metal layer 42, or may have different shapes. For example, at least one of the interior conductive layers 45 protrudes form the top metal layer 42, seen in top view of the top face 40.

The electrically non-conductive layers 41, 44 and the adjacent conductive layer 42, 45 can be applied in pairs on each other. Hence, a couple of IMS-based substrates can be mounted on each other to form the overall auxiliary substrate 4. According to Figure 4, there can be a first substrate at the bottom side 49 formed of the insulation layer 41 and the adjacent interior conductive layer 45, a second substrate comprising the lower interior insulating layer 44 and the upper interior conductive layer 45, and a third substrate comprising the upper interior insulating layer 44 and the top metal layer 42. These substrates can be laminated on each other.

It is possible that there are vias 48 to interconnect the layers 42, 45. As an option, there is at least one interior conductive layer 45 not connected to the top face 40. Such an interior conductive layer 45 may provide some shielding against electromagnetic fields, and to reduce parasitic inductance between a gate signal on the auxiliary substrate 4 and emitter/source currents on the main substrate 2.

Optionally, there is at least one resistor 6 as a first type of electric device on the top face 40. Further, there can be at least one sensor chip 61 as a second type of electric device and/or at least one IC 62 as a third type of electric device. For example, the IC 62 is located adjacent to the top metal layer 42, seen in top view of the top face 40.

That is, the auxiliary substrate 4 can be provided with at least two different kinds of electric devices. Such electric devices are, for example, at least one of resistors or integrated circuits or sensors like negative temperature coefficient thermistors or also positive temperature coefficient thermistors.

In Figure 4 it is also illustrated that the insulator layer 41 can be of multi-layer fashion, and the same may apply for the interior insulating layers 44, not explicitly shown. Otherwise, the insulator layer 41 is of only one layer.

Thus, the insulator layer 41 can comprise a resin layer 81 and a bottom sub-layer 83 at the bottom side 49 and optionally also a top sub-layer 84 at the interior conductive layer 45 or, if there is no such layer, at the top metal layer 42. For example, the sub-layers 83, 84 are so-called prepreg layers, for example, comprising FR4. For example, the sub-layers 83, 84 are of a polymer like an epoxy resin. The term 'prepreg' means pre-impregnated and refers, for example, to composite fibers where a thermoset polymer matrix material, such as epoxy, or a thermoplastic resin is already present around the fibers. The optional fibers may take the form of a weave and the matrix is used to bond them together and to other components during manufacture. At first, the thermoset matrix is only partially cured to allow easy handling. Hence, using a prepreg allows one to impregnate the fibers on a flat workable surface, or rather in an industrial process, and then later form the impregnated fibers to a shape which could otherwise prove to be problematic.

By means of such sub-layers 83, 84, the insulator layer 41 can efficiently be laminated to the top metal layer 42, or to the interior conductive layer 45, as well as to the main substrate 2. It is possible that such optional sub-layers 83, 84 dissolve in a lamination process and may only hardly be detectable in the finished power semiconductor module 1. The same applies to all other exemplary embodiments.

As a further option, in Figure 4 it is illustrated that the resin layer 81 is filled with isolating particles providing an improved isolation capability and an improved heat dissipation. For example, particles 82 of at least one ceramic material are used, like particles 82 made of AlN, Al₂O₃, Si₃N₄, or BN, or also SiO₂. In contrast to IMS substrates available on the market, the structure built of the isolator layer 41 and the top metal layer 42 is not laminated to a thick metal sheet used as base material. Due to a lamination process, it is possible that the particles 82 penetrate at least one of the sub-layers 83, 84 and may get in direct contact with the top metal layer 42, the optional adjacent interior conductive layer 45 and the main substrate 2.

Otherwise, the same as to Figures 2 and 3 may also apply to Figure 4, and vice versa.

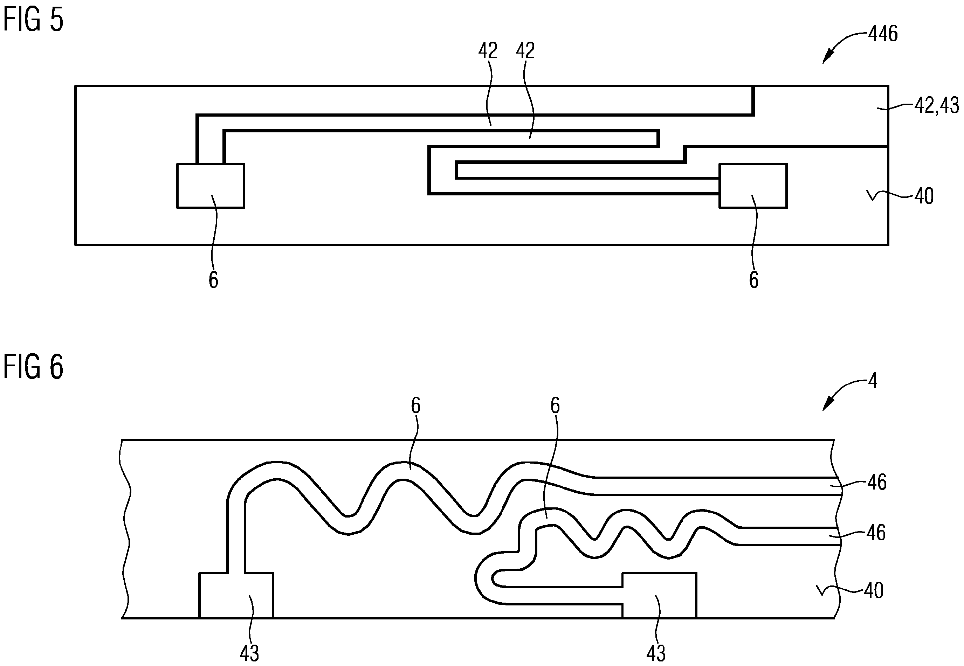

In the exemplary auxiliary substrates 4 illustrated in Figures 5 to 7, the focus is on the electrical circuitry at the top face 40. These aspects can apply to all other exemplary embodiments of the power semiconductor module 1, individually or collectively. The aspects not mentioned in Figures 5 to 8 may be realized like in the other exemplary embodiments.

According to Figure 5, the top metal layer 42 at the top face 40 is shaped into conductor tracks 46. At least some of the conductor tracks 46 have the same length to avoid electrical path length differences due to the auxiliary substrate 4. Thus, a contact area 43 for the electric connection means, like a bond wire, may be located at an end of the top face 40, but all electrical devices like the resistors 6 are connected with the same electrical path lengths. That is, when using several conductor tracks 46, the length of the signal paths related to each first semiconductor chip 3 can be individually adjusted to achieve an improved homogeneity in switching of all electrically parallel devices.

Moreover, parasitic inductance of the electrical paths of gate signals can be reduced by a trace layout providing parallel or antiparallel signal paths, compare Figure 5, too.

In Figure 5, the resistors 6 as exemplary additional electrical devices are realized by separate devices mounted on the top face 40. Contrary to that, see Figure 6, the resistors 6 can be prepared by a corresponding layout of the conductor tracks 46. This facilitates the replacement of the separately mounted gate resistors of Figure 5, accompanied by a corresponding cost saving. Additionally, resistors prepared by trace layout give the option to realize gate resistors having an optimum resistance for each chip facilitating even higher homogeneity in switching.

There can be individual contact areas 43 for the resistors 6, see Figure 6, or there can be just one common contact area 43 for all the resistors 6. Both variants can in principle be applied to all the exemplary embodiments.

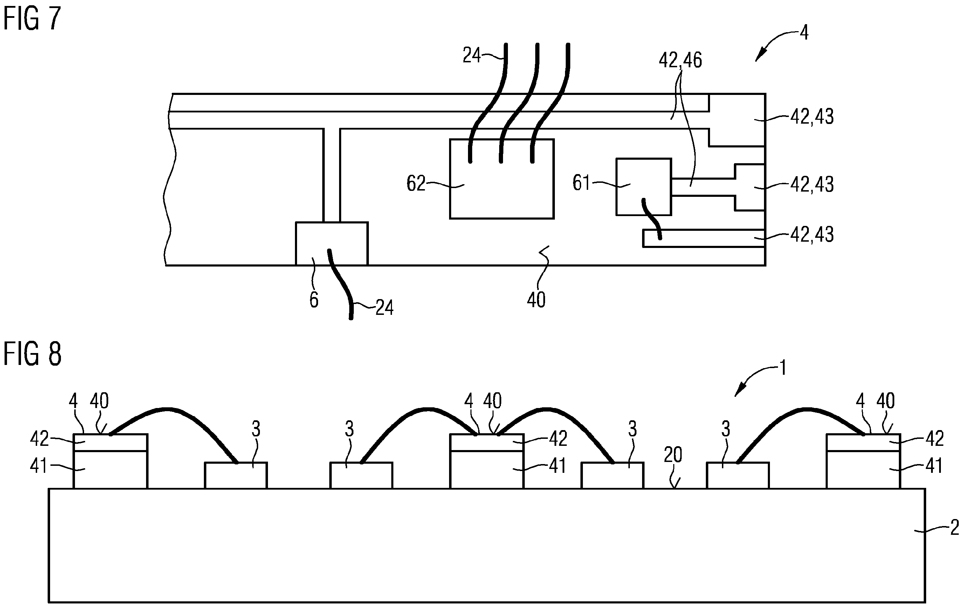

According to Figure 7, there is at least one sensor chip 61 as a second type of additional electric devices, beside the resistors 6 as a first kind of additional electric device. As an option, there can be a further, third type of additional electric devices, like ICs 62. It is possible that the devices 6, 61, 62 are directly electrically connected to the top face 40 by means of the contact areas 43 and/or the devices 6, 61, 62 are connected by means of electric connection means 24, like bond wires.

Hence, the use of an IMS-based auxiliary substrate 4 with conductor tracks 46 facilitates the integration of further functionalities like auxiliary emitter/source and auxiliary collector or electrical paths for the interconnection of integrated sensors like thermistors. Additionally, conductor tracks 46 may be used for multiple signal paths in the case of an intelligent power semiconductor module 1 comprising, for example, at least on IC 62.

In all Figures 5 to 7, electrical interconnections between the auxiliary substrate 4 and the main substrate 2 may alternatively or additionally be provided by ribbons, foils or clips instead of the bond wires as the electric connection means 24.

For example, each one of the conductor tracks 46 is assigned to up to two or to up to four of the first semiconductor chips 3, not shown in Figures 5 to 7. For example, there is a one-to-one assignment between these conductor tracks 46 and the respective first semiconductor chips 3 so that separate conductor tracks 46 can be assigned to the respective individual first semiconductor chips 3. Otherwise, a plurality of the first semiconductor chips 3 is assigned to the same conductor track 46.

Hence, the resistors 6 in Figures 5 to 7 are electric devices mounted on the top face 40 of the at least one auxiliary substrate 4, or the resistors 6 can also be structures formed in the top face 40, that is, in the top metal layer 42, but otherwise the resistors could in each case also be formed in an interior of the at least one auxiliary substrate 4, for example, if the at least one auxiliary substrate 4 is of multi-layer fashion.

Otherwise, the same as to Figures 2 to 4 may also apply to Figures 5 to 7, and vice versa.

In Figure 8, another exemplary embodiment of the power semiconductor module 1 is illustrated. In this case, there is more than one auxiliary substrate 4, for example, three auxiliary substrates 4. All the auxiliary substrates 4 can be of the same design, although different numbers of first semiconductor chips 3 may be assigned to the auxiliary substrates 4. The same applies to all other exemplary embodiments.

Moreover, in Figure 8 is shown that the top face 40 is in each case formed by the respective metal layer 42 only. The top metal layers 42 can thus be of continuous, plane fashion, but as an alternative can also be structured to comprise contact areas and/or conductor tracks like in Figures 5 to 7. Thus, there are no resistors or other additional electric devices on the top faces 40, contrary to what is illustrated in Figure 4, for example. The same applies to all other exemplary embodiments.

For example, seen in top view of the top face 40, the first semiconductor chips 3 are arranged along two sides of at least one of the auxiliary substrates 4 so that said auxiliary substrate 4 is located between the respective first semiconductor chips 3. Said auxiliary substrate 4 may be a line of symmetry concerning the arrangement of the assigned first semiconductor chips 3. Electrical contact points for the first semiconductor chips 3 on the top face 4 could also be arranged in a symmetric manner. If there is a plurality of the auxiliary substrates 4, this can apply for one of for more than one of the auxiliary substrates 4, other than shown in Figure 8.

Otherwise, the same as to Figures 2 to 7 also applies to Figure 8.

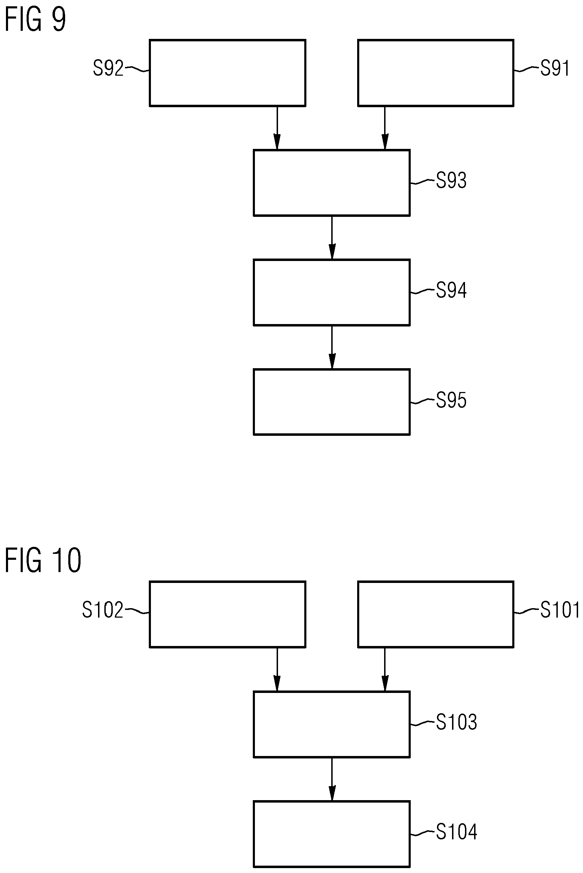

Figure 9 and 10 illustrate block diagrams of methods to manufacture the power semiconductor modules 1.

According to Figure 9, in method step S92 the insulation layer 41 is provided. The insulation layer 41 may comprise the resin layer 81 with the particles 82 as well as the bottom sub-layer 83 and the top sub-layer 84 as illustrated in Figure 4. The resin layer 81 may be formed by molding or casting, and the sub-layers 83, 84 may be applied by a coating step, wherein the sub-layers 83, 84 may be prepregs.

In method step S91, the top metal layer 42 is provided. For example, the top metal layer 42 is a metal sheet or a metal foil.

In method step S93, the top metal layer 42 is laminated onto the resin layer 81 by curing the top sub-layer 84.

In optional method step S94, if a large sheet is laminated, the auxiliary substrates 4 are singulated out of said sheet.

According to method step S95, the at least one auxiliary substrate 4 is applied to the main substrate 2, for example, by lamination. In this lamination step, the bottom sub-layer 83 may be cured.

Hence, the realization of the main substrate 2 with an implemented IMS-based auxiliary substrate 4 is done by a comparably simple process. First, large sheets of the resin isolating material and the metal foil used for the top metal layer are produced. A typical size of these initial resin sheets and metal foils is in the range of 50 x 50 cm², for example. The large resin sheet and the metallization foil are joined together by a first lamination process. Then the laminated structure is singulated to the single auxiliary substrates 4 by a cutting process, for example. Here, typical cutting processes like stamping or laser cutting may be used. Finally, the singulated auxiliary substrates 4 are joined to the metallization 22 at the top layer 20 of main substrates 2 using the insulation layer 41, for example, the bottom sub-layer 83, for adhesion by a second lamination process applying enhanced temperature and pressure. The second lamination process can be done by a substrate supplier, but also by a manufacturer of power semiconductor modules 1 himself.

According to the method of Figure 10, in method step S102 the at least one main substrate 2 is provided, and in method step S101 the at least on top metal layer 42 is provided.

Then, in method step S103, the main substrate 2 and the top metal layer 42 are arranged in their final relative positions. This is done, for example, in a mold tool.

Then, in method step S104 the insulation layer 41 is created between the respective main substrate 2 and the assigned top metal layer 42. The insulation layer 41 may in this case be created by molding or casting. In such a method, there is no need for lamination steps and/or sub-layers 83, 84.

The invention described here is not restricted by the description given with reference to the exemplary embodiments. Rather, the invention encompasses any novel feature and any combination of features, including in particular any combination of features in the claims, even if this feature or this combination is not itself explicitly indicated in the claims or exemplary embodiments.

### List of Reference Signs

- 1: power semiconductor module
- 2: main substrate
- 20: top layer
- 21: ceramic layer
- 22: metallization
- 24: electric connection means
- 25: terminal region
- 26: contact surface/conductor path
- 3: first semiconductor chip
- 4: auxiliary substrate
- 40: top face
- 41: insulation layer
- 42: top metal layer
- 43: contact area
- 44: interior insulating layer
- 45: interior conductive layer
- 46: conductor track
- 48: via
- 49: bottom side
- 6: resistor, first kind of additional electric device
- 61: sensor chip, second type of additional electric device
- 62: IC, third type of additional electric device
- 81: resin layer
- 82: inorganic particle
- 83: bottom sub-layer
- 84: top sub-layer
- 9: further substrate
- 91: ceramic layer
- 10: modified power semiconductor module
- S..: method step

## Claims

1. A power semiconductor module (1) comprising:
- a main substrate (2),
- at least one first semiconductor chip (3) mounted on the main substrate (2), and
- at least one auxiliary substrate (4) mounted on the main substrate (2), the at least one auxiliary substrate (4) comprises a top face (40) remote from the main substrate (2), wherein
- the at least one auxiliary substrate (4) comprises an insulation layer (41) which is based on an organic material and which is in direct contact with the main substrate (2), and comprises a top metal layer (42) forming at least part of the top face (40).

2. The power semiconductor module (1) according to the preceding claim,
wherein the at least one auxiliary substrate (4) is attached to the main substrate (2) by means of the insulation layer (41) and the top metal layer (42) is in direct contact with the insulation layer (41).

3. The power semiconductor module (1) according to any one of the preceding claims,
wherein the insulation layer (41) comprises or consists of a resin layer (81) filled with inorganic particles (82).

4. The power semiconductor module (1) according to the preceding claim,
wherein the insulation layer (41) further comprises a bottom sub-layer (83) directly between the resin layer (81) and the main substrate (2), the bottom sub-layer (83) is of an epoxy resin and has a sub-layer thickness which is at most 20% of an overall thickness of the insulation layer (41).

5. The power semiconductor module (1) according to any one of the preceding claims,
wherein the at least one auxiliary substrate (4) is an insulated metal substrate and the main substrate (2) is a direct bonded copper substrate.

6. The power semiconductor module (1) according to any one of the preceding claims,
comprising a plurality of the first semiconductor chips (3) all of which are mounted on the main substrate (2),
wherein the at least one auxiliary substrate (4) provides a common contact platform for the first semiconductor chips (3), and from each one of the first semiconductor chips (3) an electric connection means (24) runs onto the at least one auxiliary substrate (4).

7. The power semiconductor module (1) according to the preceding claim,
wherein the at least one auxiliary substrate (4) comprises a plurality of resistors (6), each of the plurality of resistors (6) is assigned to up to two of the first semiconductor chips (3),
wherein the plurality of resistors (6) are electric devices mounted on the top face (40) of the at least one auxiliary substrate (4), or the plurality of resistors (6) are structures formed in the top face (40) or in an interior of the at least one auxiliary substrate (4).

8. The power semiconductor module (1) according to any one of claims 6 and 7,
wherein the top face (40) of the at least one auxiliary substrate (4) comprises conductor tracks (46), each one of the conductor tracks (46) is assigned to up to two of the first semiconductor chips (3), and
wherein the conductor tracks (46) have different lengths so that otherwise existing length differences of electrical connection lines in the power semiconductor module (1) to the first semiconductor chips (3) running over the at least one auxiliary substrate (4) are compensated for.

9. The power semiconductor module (1) according to any one of claims 6 to 8,
comprising at least two of the auxiliary substrates (4) all of which are mounted on the main substrate (2),
wherein each one of the auxiliary substrates (4) is electrically connected to at least one of the first semiconductor chips (3).

10. The power semiconductor module (1) according to any one of the preceding claims,
wherein the at least one auxiliary substrate (4) is a multilayer substrate, so that the at least one auxiliary substrate (4) comprises an interior conductive layer (45).

11. The power semiconductor module (1) according to any one of the preceding claims,
wherein a top layer (20) of the mains substrate (2), where the at least one auxiliary substrate (4) is mounted, is formed of a metallization (22) so that the at least one auxiliary substrate (4) is directly applied on said metallization (22).

12. The power semiconductor module (1) according to any one of the preceding claims,
wherein the power semiconductor module (1) is configured to handle a maximum current of at least 10 A.

13. A method for manufacturing a power semiconductor module (1) according to any one of the preceding claims, comprising:
A) providing the main substrate (2), and
B) mounting the at least one auxiliary substrate (4) onto the main substrate (2),
wherein in step B) the mounting the at least one auxiliary substrate (4) is comprises applying an elevated temperature on the respective insulation layer (41).

14. The method according to the preceding claim,
wherein a fabricating of the at least one auxiliary substrate (4) is done prior to step B) and the fabricating comprises:
C1) providing the top metal layer (42),
C2) providing the insulation layer (41), and
C3) laminating the top metal layer (42) onto the insulation layer (41),
wherein in step B) mounting the at least one auxiliary substrate (4) onto the main substrate (2) comprises laminating the at least one auxiliary substrate (4) onto the main substrate (2).

15. The method according to claim 13,
wherein a fabricating of the at least one auxiliary substrate (4) comprises:
C1) providing the top metal layer (42),
C4) arranging the main substrate (2) and the top metal layer (42) in their final relative positions,
C5) creating the insulation layer (41) between the main substrate (2) and the top metal layer (42),
wherein step C5) includes molding or casting the insulation layer (41).
